Europäisches Patentamt

European Patent Office

Office européen des brevets

(19)

(11) Publication number: **0 371 719**
**A2**

## EUROPEAN PATENT APPLICATION

(12)

(21) Application number: 89312264.8

(22) Date of filing: 27.11.89

(51) Int. Cl.5: **H04B 1/20, H04N 5/00,**
**G08C 19/00**

(30) Priority: 29.11.88 JP 301233/88

(43) Date of publication of application:
06.06.90 Bulletin 90/23

(84) Designated Contracting States:
BE DE FR GB NL

(71) Applicant: Matsushita Electric Industrial Co.,
Ltd.
1006, Oaza Kadoma
Kadoma-shi, Osaka-fu(JP)

(72) Inventor: Yamamoto, Terumasa
20-18 Teratanicho
Takatsuki-shi(JP)
Inventor: Nakatsu, Hiromasa
13-20 Kitabatake-3-chome
Abeno-ku Osaka-shi(JP)

(74) Representative: Votier, Sidney David et al
CARPMAELS & RANSFORD 43, Bloomsbury
Square
London WC1A 2RA(GB)

(54) **Apparatus control system using on-screen display.**

(57) An apparatus control system in which a controller (3) and a plurality of terminal devices (6-n) are connected via the respective communication control units (1) to a common communication path (5). Each terminal device is provided with a picture constituent information keep section (61, ..., or n1) for keeping information related to picture constituent elements for each display picture unit. The controller includes a picture data keeping section (31) for keeping display element information such as characters, basic pictures of a plurality of kinds, and an image generating software module so as to produce, based on the information related to picure constituent elements, a picture to be displayed by use of display element information. As a result, even when a new terminal is connected to the system, a display picture can be displayed for a control of the new terminal without requiring the controller to achieve a modification associted with the new terminal.

FIG. I

## APPARATUS CONTROL SYSTEM USING ON-SCREEN DISPLAY

### BACKGROUND OF THE INVENTION

The present invention relates to a control system using an on-screen display for controlling and for monitoring apparatuses based on character strings and graphic screens displayed on a cathode-ray tube (CRT) or the like.

Recently, as means for achieving an apparatus control, there has been broadly adopted an infrared-ray remote control system. Particularly, in the field of audio and video apparatuses, almost all such control systems are of this type.

However, the transmitter for the remote control in this situation is exclusively used for each apparatus (e.g. a video tape recorder (VTR) is provided with a remote controller dedicated thereto and a television set is associated with a remote controller to be exclusive therefor in most cases). It is hence necessary to prepare a remote control transmitter which is capable of controlling a plurality of kinds of apparatuses to be controlled. These days, there has been introduced a remote control transmitter of a learning type, which is operative for a limited number of apparatus types. Moreover, when the number of apparatus types is increased, there appear disadvantages that a large number of operation buttons are required and that the size of the transmitter itself becomes greater.

These disadvantages are solved by the following method.

According to such method (JP-A-60-132324), in a system in which a TV set, a controller, and a plurality of terminal devices or terminals are connected via control lines, the controller displays on the TV set control information necessary for the control of the terminals such that one of the control information items thus displayed on a screen of the TV set is selected. In the controller, based on a selection signal from a remote control transmitter and the control information item currently displayed on the screen of the TV set by the controller, an associated control content is selected so as to transmit a control signal to terminals, thereby controlling the terminal devices.

This method is advantageous that the operation is facilitated because the operation is conducted while the operator is visually checking the display picture and that the control result can be confirmed on the display picture.

However, this conventional method is attended with a disadvantageous feature. Namely, when the number of terminal devices to be connected to the system is increased or when the control content of terminal devices is to be altered, it is necessary to change the display picture for the terminal control kept by the controller.

### SUMMARY OF THE INVENTION

It is therefore an object of the present invention to provide an apparatus control system employing an on-display to solve the problems above.

Namely, in the apparatus control system, even when a terminal is additionally installed or even when the control content of a terminal currently incorporated in the system is changed, a display picture for the control thereof can be displayed on the display without requiring the controller to achieve the change processing associated therewith.

In order to achieve the object above, according to the present invention, there is provided an apparatus control system using an on-screen display comprising a controller and a plurality of terminal devices, said terminal devices being connected via respective communication control units to a common communication path. The controller is characterized by including a display section, an input section for selecting control information related to a terminal displayed on the display section, and a control section for processing the selected information supplied from the input section to send a control signal associated with the selected information via the communication control unit to the terminal and for receiving via the communication control unit information related to screen constituent elements from the terminal to display on the display section a control picture based on the received content.

### BRIEF DESCRIPTION OF THE DRAWING

These and other objects and advantages of the present invention will become apparent by reference to the following description and accompanying drawings wherein:

FIG. 1 is a block diagram schematically showing the configuration of an embodiment of the apparatus control system utilizing an on-screen display in accordance with the present invention;

FIGS. 2, 4, 6, and 9 are schematic diagrams showing display screens presented on the controller display section based on display picture codes transmitted from terminals to the controller;

FIGS. 3, 5, 7, and 8 are diagrams schematically showing layouts of texts communicated between terminals and the controller; and

FIG. 10 is a block configuration diagram showing the constitution of an alternative embodiment according to the present invention.

## DESCRIPTION OF THE PREFERRED EMBODIMENTS

Referring now to the drawings, a description will be given of an embodiment of the apparatus control system employing an on-screen display according to the present invention.

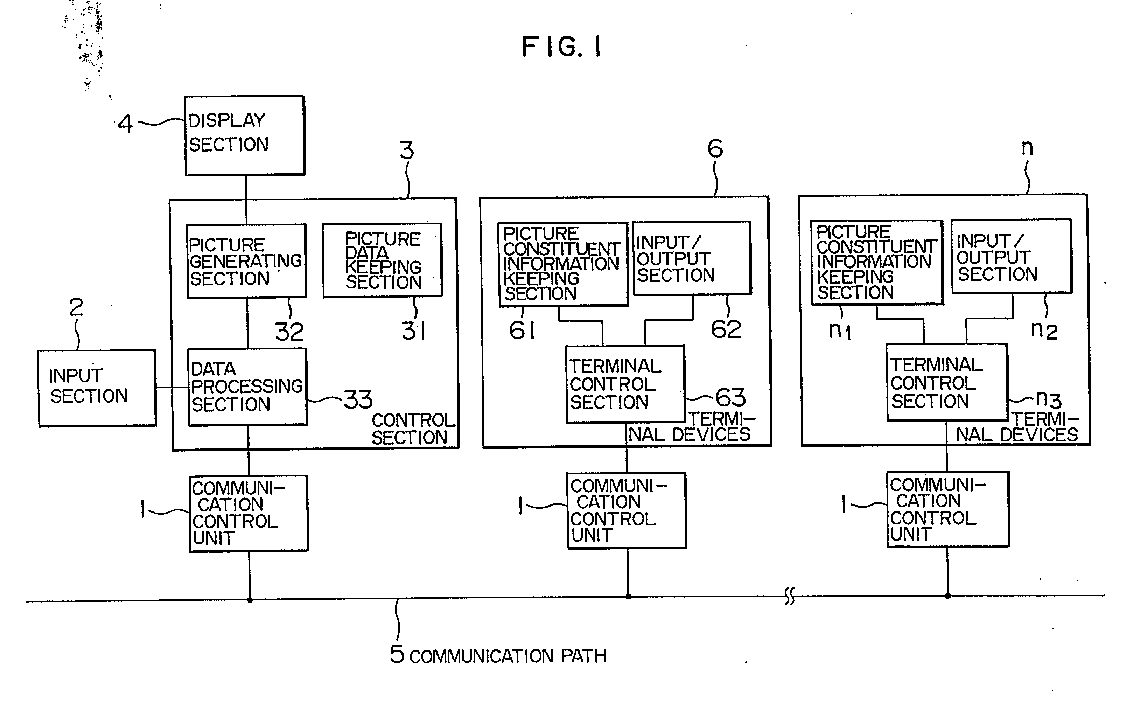

The configuration of FIG. 1 includes a communication control unit 1 for communicating data between the controller and the terminals via a communication path or route in conformity with a predetermined communication procedure.

Reference numeral 2 indicates an input section, for example, a remote control pad for selecting control information related to a terminal displayed on the display section of the controller so as to input the selected information to the control section of the controller.

Numeral 3 denotes a control section for processing the selected information supplied from the input section 2 to send control signals associated with the information via the communication control unit 1 to a terminal and for receiving via the communication control unit 1 information related to screen constituent elements from the terminal, thereby displaying on a display section 4 a control picture based on the content thus received.

The information related to the picture constituent elements includes, for example, selection information to indicate a display element information item to be selected, display position information to designate a position on the display picture where the selected display element information item is to be displayed, and color information to denote a color to be used for the display of the selected display element information item.

The display element information items include, for example, characters, graphic elements such as a circular image, a star, a hart image, and an arrow, and image generating or drawing software modules constituting the software to generate basic graphic images such as a circle and a line segment.

The controller further comprises a display section 4 for displaying the control picture produced by the control section for the terminal.

The controller includes the input section 2, the control section 3, and the display section 4.

The control section 3 is connected via the communication control unit 1 to a common communication path 5.

Reference nuemrals 6 to n denote terminals including a VTR, a CD, and a VD, which are respectively linked via the communication control unit 1 to a common communication path 5.

The control section 3 includes therein a picture data keeping section 31, a picture generating section 32, and data processing section 33.

The picture data keeping section 31 keeps the display element information items.

The picture generating section 32 generates, based on information related to the picture constituent elements from the terminals 6 to n, pictures to be displayed by use of the display element information items kept in the picture data keeping section 31. This processing may be implemented, for example, by use of an image generating program.

The data processing section 33 processes input information from the input section 2 and data items from the terminals 6 to n to transfer resultant data to the screen generate section 32 and the communication control unit 1, thereby achieving a sequence control.

The terminals 6 to n respectively include picture constituent information keeping sections 61 to n1, input/output sections 62 to 6n, and terminal control sections 63 to n3.

The picture constituent information keeping sections 61 to n1 keep information items related to the screen constituent elements. These information items may be kept therein in units of the display picture of the display section 4 of the controller 3 or may be kept in association with partial regions of the display picture.

When the display picture is used as the unit to keep the information, the processing to send the information to the controller is facilitated. When the partial regions are to be set as the unit, the transmission data is minimized, for example, when a portion of the display picture is to be changed.

The input/output sections 62 to n2 are disposed to operate the associated terminals and to display terminal states.

The terminal control sections 63 to n3 process data received from the input/output sections 62 to n2 and the communication control unit 1 so as to display necessary information on the input/output sections 62 to n2, to select and to output information related to necessary picture constituent elements via the communication control unit 1 to the controller, and to control internal operations of the terminals 63 to n3.

Next, a description will be given of operations of the apparatus control system configured as above in accordance with the present invention.

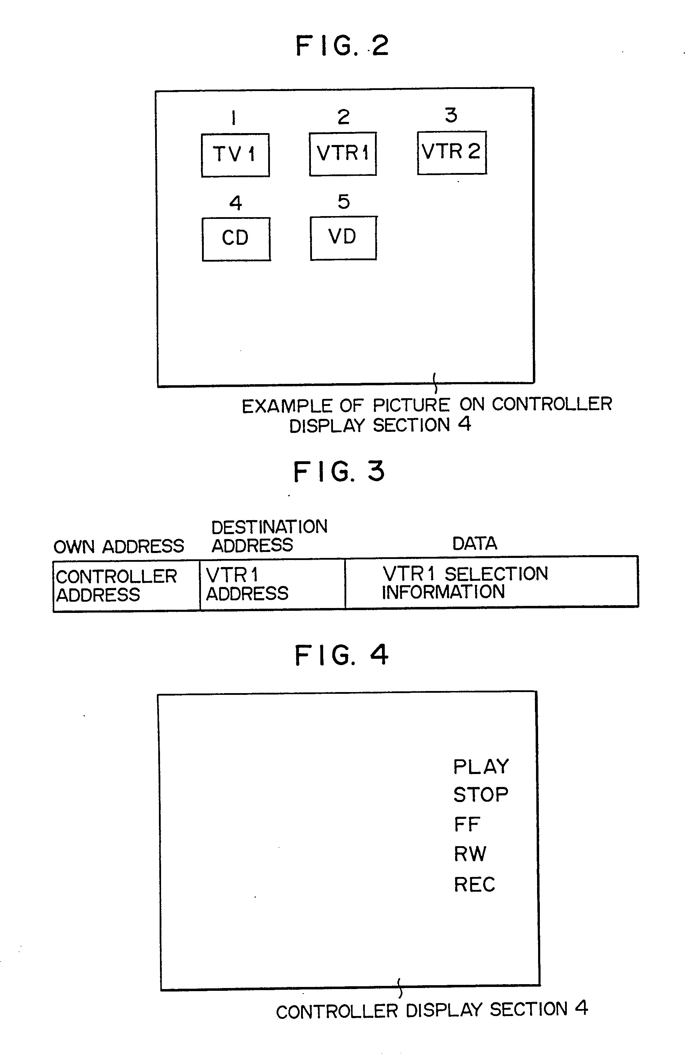

When the system is set up and the controller is powered, the display section 4 displays a list of connected units as shown in FIG. 2.

This display is accomplished as follows.

The controller supervises information about the tyeps or kinds of the terminals 6 to n connected to the communication path 5.

For recognizing the types of terminals 6 to n connected to the communication path 5, there may be adopted a method in which, as described in pages 60-61 and page 80 of the Home Bus System Specifications, the terminals connected to the communication path 5 send at the system setup phase information items such as the attributes, for example, names and maker names to the controller. On receiving the information items, the controller identifies the details about the terminals connected to the communication path 5.

Based on the infromation about the terminals, the controller displays related information items on the display section 4.

For the display, the layout and other items are beforehand determined in the controller. The picture generating section 32 of the controller gets picture data from the picture data keeping section 31 so as to display the data on the display section 4.

Next, an apparatus or a terminal to be controlled is selected by use of the input section 2.

The selection may be accompslished such that, for example, like in an example shown in FIG. 2, there are used numbers (1 ... TV, 2 ... VTR, 3 ... VTR2, 4 ... CD, 5 ... VD) corresponding to the respective terminal names. Or, an appropriate cursor is displayed so as to be moved to a position of an objective terminal name, thereby selecting the terminal.

A description will now be given in detail of a case where VTR1 is selected.

When the VTR1 is indicated for a selection from the input section 2, the data processing section 33 of the control section 3 first recognizes the selection of the VTR1 so as to send to the VTR1 a text reporting that the VTR1 is selected. The text comprises, as shown in FIG. 3, a controller address as the own address, a VTR1 address as a destination address, and VTR1 selection information as a data field.

When the text is received by the VTR1, the terminal control section (63, ..., or 6n) interprets the content of the text to decide an action to be next taken. In this case, for the slection of the VTR1, control is passed to a sequence to display a picture necessary for the control of the VTR1 on the display section 4 of the controller.

Code data related to the picture is first obtained from the screen constituent information keeping section(61, ..., or n1) storing therein codes associated with pictures to be displayed.

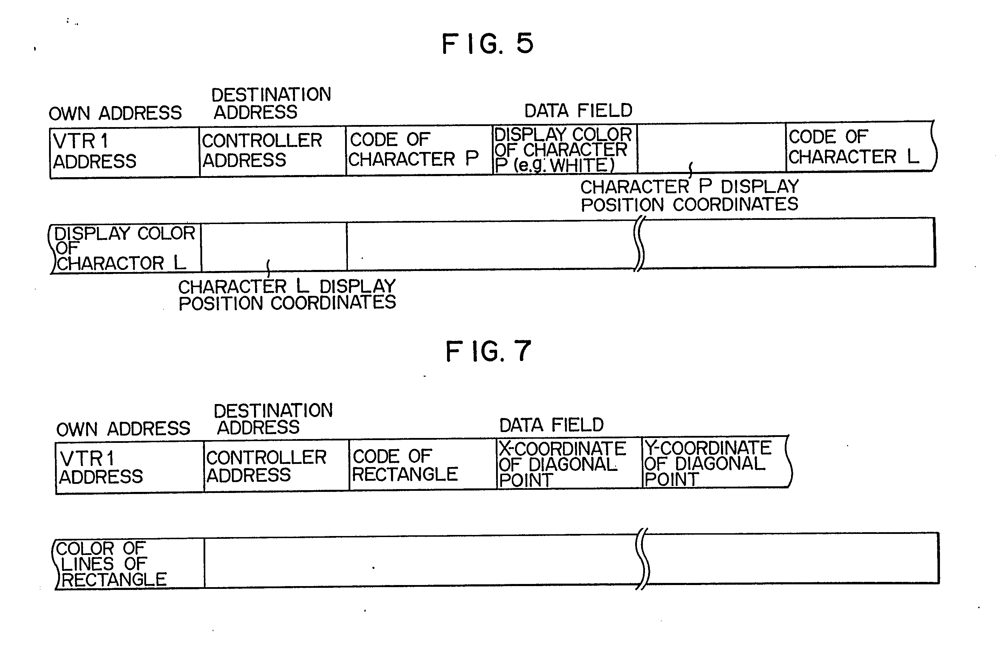

FIG. 4 shows a display example of a picture including only characters, whereas FIG. 5 is a schematic diagram showing a text transmitted from the VTR1 to the controller to construct the picture of FIG. 4.

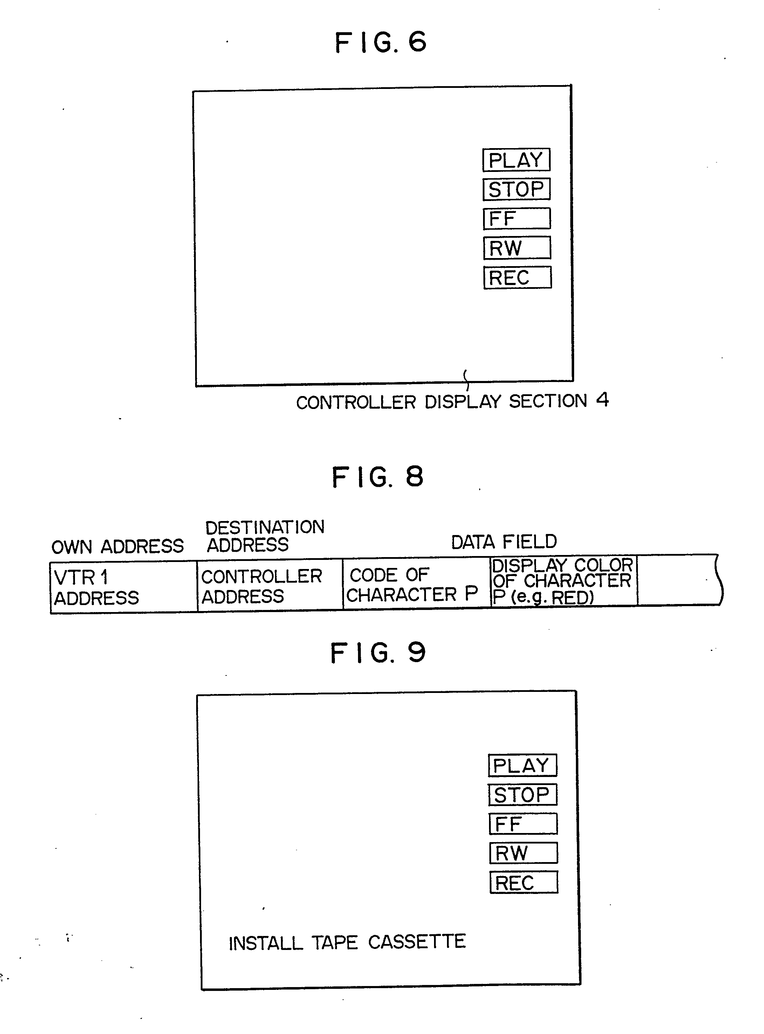

As can be seen from FIG. 5, the text comprises a VTR1 address as the own address, a controller address as a destiantion address, and a data field including code information items such as codes of characters and items related to a display color and a display position. In this data field of FIG. 5, portions or "P" and "L" of "PLAY" are shown. Naturally, for displaying character strings and grpahic images, the similar method is available. For example, as shown in FIG. 6, in a case where characters are to be displayed in rectangles, there is employed a text as shown in FIG. 7 including a code denoting a rectangle, X and Y coordinate values of the diagonal point, a line color, etc.

Subsequently, on receiving the text from the VTR1, the controller interprets the text in the data processing section 33 of the control section 3 so as to get characters corresponding to the codes and a graphic image generating module from the picture data keeping section 31. The obtained data items are processed by the picture generating section 32 to produce display data conforming to the display layout, thereby outputting the resultant data to the display section 4.

Next, while visually checking the display picture (FIG. 4 or 6) of VTR1 thus displayed on the display section 4, the operator achieves a control operation from the input section 2.

For example, when "PLAY" is selected, according to the sequence above, the controller sends a text of a code associated with "PLAY" to the VTR1. On receiving the text, the VTR1 sets the own system to the "PLAY" state if possible. At the same time, in order to notify the condition of "PLAY" to the controller, the pertinent display information is sent to the controller.

For example, in a case where the color of "PLAY" currently being displayed is to be changed, a text as shown in FIG. 8 is transmitted to the controller in conformity with the sequence similar to that described above. When this text is received, the controller displays characters associated with the received code information items according to the similar procedure as employed above. The method of specifying the display content has been described only by way of example. It is also possible to specify the display content at a time by use of character strings.

On the other hand, when the VTR1 is not loaded with a tape cassette for a playback operation, the playback operation cannot be achieved. In such a situation, by keeping a guidance picture as shown in FIG. 9 in the picture constituent information keeping sections (61 to 6n), the guidance picture can be displayed on the display section 4 of the controller in the similar fashion.

The response signals associated with the control picture constitution and the guidance can be naturally produced in an arbitrary manner on the terminal side.

By repeately achieving the operations above, the operator can operate the terminal while visually checking the display screen.

In accordance with the control system of this embodiment, the necessary picture information related to the terminals to be connected to the communication path need not be necessarily kept in the controller. The control system can flexibly cope with the increased in the number of terminals and with functional modifications.

Next, a description will be given of an embodiment in which a record reservation is conducted on a VTR as a terminal in the control system according to the present invention.

The VTR of this embodiment includes means for comparing a record period of time determined by inputted record start and end points of time and a remaining tape amount of a tape cassette installed in the VTR. Depending on the results of the comparison, the means displays associated messages.

When the message is sent via the communication route 5 to the controller, the message is displayed on the display section 4.

Consequently, also for the user operating at a remote terminal, such a message associated with the relationship between the record period of time and the remaining tape amount can be reported.

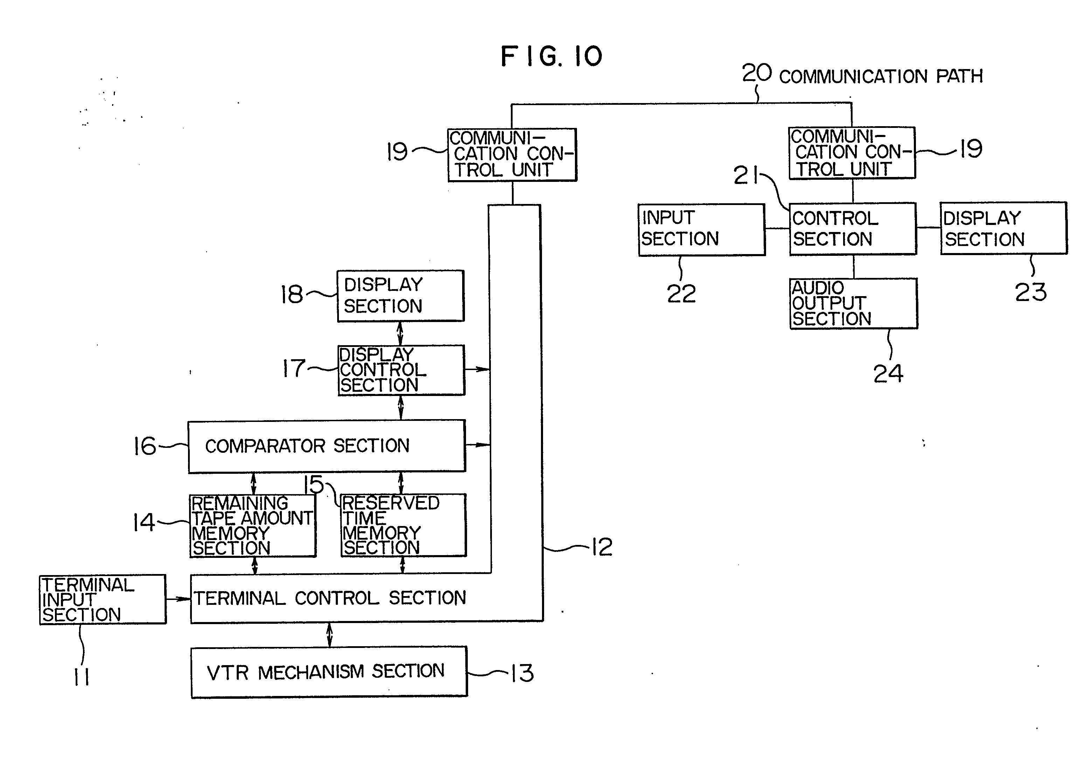

FIG. 10 shows a system configuration in which a VTR having a record reserving function or a timer recording function is connected to a communication path.

This constitution includes a terminal input section 11 for inputting a record point of time, a terminal control section 12, a VTR mechanism section 13, a remaining tape amount memory section 14 for storing therein a remaining amount data (for the recording operation) of the tape cassette installed in the VTR, a reserved time memory section 15 for memorizing a record period of time determined by the inputted record start and end points of time, a comparator section 16 for comparing the data of the remaining tape amount memory section 14 with that of the reserved time memory section 15, a display control section 17 for producing a message associated with the comparison result, and a display section 18. Namely, the VTR is constituted with the above components.

Reference numerals 19 and 20 denote a communication control unit and a transmission path, respectively.

The system further includes a control section 21, an input section 22 comprising a remote control pad and the like, a display section 23, and an audio output section 24. That is, the controller is constituted with these components.

The controller in this embodiment is provided, in addition to the display section 23, with the audio output section 24 as output means.

The VTR and the controller are connected via the communication control unit 19 to the communication path 20.

Next, a description will be given of operations of a remote control.

The reserved record start and end points of time supplied from the input section 22 are received by the control section 21 so as to be transmitted via the communication control unit 19 to the control section 12 as the transmission destination.

The control section 12 computes a record period of time to store the result of the computation in the reserved time memory section 15.

On the other hand, in the VTR, the remaining data (available record period of time) of the tape of the tape cassette installed in the VTR is measured to be memorized in the remaining tape amount memory section 14. The comparator section 16 compares the data of the remaining tape amount memory section 14 with that of the reserved time memory section 15. Resultantly, the display control section 17 produces a message corresponding to the comparison result.

The messsage is information concerning picture constituent elements kept in the picture constituent element information keeping section (not shown) integrated in the display control section 17.

The terminal control section 12 sends the message via the communication control unit 9 to the controller.

The control section 21 of the controller is responsive to the received message to accomplish the following operations by use of display element information kept in the screen data keep section (not shown) integrated in the control section 21.

(1) When the remaining tape amount is equal to or more than the reserved period of time, the control section 21 displays "Reserved period of time is available for the recording", etc.

(2) When the remaining tape amount is less than the reserved period of time, the control section 21 displays "XX hours are available for the recording. For the overall recording, install another tape cassette", etc.

While particular embodiments of the invention have been shown and described, it will be obvious to those skilled in the art that various changes and modifications may be made without departing from the present invention in its broader aspects.

## Claims

1. A apparatus control system using an on-screen display (4) including a controller (3) and a plurality of terminal devices (6-n), each said terminal device being connected to a communication control unit (1) to a common communication path (5), said controller including:

a display section (4);

an inpt section (2) for selecting control information related to a terminal device displayed on said display section, thereby inputting the selected information;

a control section (33) for processing the selected information supplied form said input section to transmit a control signal associated with the selected information via said communication control unit to said terminal device and for receiving via said communication control unit information related to picture constituent elements from said terminal device to display on said diplay section a control screen based on the received content.

2. An apparatus control system according to Claim 1 wherein each said terminal device includes a picture constituent information keep section (61-n1) for keeping therein information related to picture constituent elements for each display picture unit or for each partial display picture unit.

3. An apparatus control system according to Claim 2 wherein said control section comprises a picture data keeping section (31) and a picture generating section (32),

said picture data keeping section keeps display element information such as characters, basic pictures of a plurality of kinds, and image generating software module,

said picture generating section generating, based on information related to picture constituent elements from the terminal device, a picture to be displayed by use of display element information kept in said picture data keeping section.

# F I G. 1

EP 0 371 719 A2

5 COMMUNICATION PATH

B5263

# FIG. 2

| 1 | 2 | 3 |
|---|---|---|
| TV 1 | VTR 1 | VTR 2 |

| 4 | 5 |
|---|---|
| CD | VD |

EXAMPLE OF PICTURE ON CONTROLLER
DISPLAY SECTION 4

# FIG. 3

| OWN ADDRESS | DESTINATION ADDRESS | DATA |
|---|---|---|
| CONTROLLER ADDRESS | VTR 1 ADDRESS | VTR 1 SELECTION INFORMATION |

# FIG. 4

PLAY
STOP
FF
RW
REC

CONTROLLER DISPLAY SECTION 4

## F I G. 5

| OWN ADDRESS | DESTINATION ADDRESS | DATA FIELD | | | | |
|---|---|---|---|---|---|---|
| VTR 1 ADDRESS | CONTROLLER ADDRESS | CODE OF CHARACTER P | DISPLAY COLOR OF CHARACTER P (e.g. WHITE) | | | CODE OF CHARACTER L |

CHARACTER P DISPLAY POSITION COORDINATES

| DISPLAY COLOR OF CHARACTOR L | | | |
|---|---|---|---|

CHARACTER L DISPLAY POSITION COORDINATES

## F I G. 7

| OWN ADDRESS | DESTINATION ADDRESS | DATA FIELD | | |
|---|---|---|---|---|
| VTR 1 ADDRESS | CONTROLLER ADDRESS | CODE OF RECTANGLE | X-COORDINATE OF DIAGONAL POINT | Y-COORDINATE OF DIAGONAL POINT |

| COLOR OF LINES OF RECTANGLE | | |
|---|---|---|

EP 0 371 719 A2

# FIG. 6

PLAY
STOP
FF
RW
REC

CONTROLLER DISPLAY SECTION 4

# FIG. 8

| OWN ADDRESS | DESTINATION ADDRESS | DATA FIELD | | |
|---|---|---|---|---|
| VTR 1 ADDRESS | CONTROLLER ADDRESS | CODE OF CHARACTER P | DISPLAY COLOR OF CHARACTER P (e.g. RED) | |

# FIG. 9

PLAY
STOP
FF
RW
REC

INSTALL TAPE CASSETTE

# FIG. 10

EP 0 371 719 A2